# EUROPEAN PATENT APPLICATION

(11) **EP 3 402 064 A1**
(43) Date of publication of application: **14.11.2018**
(21) Application number: 17736034.4
(22) Date of filing: 06.01.2017
(51) Int. Cl.: H02N 11/00

(54) **CONVERTER**

(30) Priority: 08.01.2016 JP 2016002330
(71) Applicant: Chiba, Seiki, Meguro-ku, Tokyo 152-0023 (JP); Waki, Mikio, Sakura-shi, Tochigi 329-1334 (JP); KCM Corporation, Nagoya-shi, Aichi 455-8668 (JP); Adeka Corporation, Tokyo 116-8554 (JP)
(72) Inventor: CHIBA, Seiki, Tokyo 116-8554 (JP); WAKI, Mikio, Tokyo 116-8554 (JP); OYA, Noriyuki, Nagoya-shi Aichi 455-8668 (JP); YOKOTA, Hideyuki, Tokyo 116-8554 (JP); HOMMA, Masatoshi, Tokyo 116-8554 (JP); ODAGIRI, Keiichi, Tokyo 116-8554 (JP); TAKENOUCHI, Hiromi, Tokyo 116-8554 (JP); SAIKI, Tomoaki, Tokyo 116-8554 (JP)
(74) Representative: Müller Hoffmann & Partner
(86) International application number: PCT/JP2017/000312
(87) International publication number: WO 2017/119497

(57) **Abstract**

A converter includes a first electrode, a second electrode, a dielectric elastomer film, and a high-dielectric-constant film. The dielectric elastomer film is disposed between the first electrode and the second electrode, and has relative dielectric constant ε1. The high-dielectric-constant film is disposed at one or both of: a location between the first electrode and the dielectric elastomer film; and a location between the second electrode and the dielectric elastomer film. The high-dielectric-constant film has relative dielectric constant ε2 that is higher than the relative dielectric constant ε1.

## Description

### Technical Field

The invention relates to a converter that performs conversion of a physical quantity with the use of a dielectric elastomer film.

### Background Art

As a converter having superior efficiency of conversion of a physical quantity, a converter (a dielectric transducer) that uses a dielectric elastomer film has drawn attention. This converter converts any physical quantity into another physical quantity by utilizing deformation (expansion and contraction, and contraction) of the dielectric elastomer film.

A converter described here has a configuration in which a polymer (a dielectric elastomer film) is disposed between two electrodes. In this converter, when a potential difference is generated between the two electrodes, the two electrodes attract each other by utilizing electrostatic force (Coulomb force). As a result, the dielectric elastomer film is deformed.

More specifically, the converter satisfies one or both of the following conditions (1) and (2).
(1) Relative dielectric constant of the dielectric elastomer film disposed between the two electrodes is higher than relative dielectric constant of air. It is to be noted that the relative dielectric constant of the air (dry air at 20°C) is assumed to be 1.000536 on the basis of Chronological Scientific Tables.
(2) Each of the two electrodes has flexibility. It is therefore possible for each of the two electrodes itself to be deformed (expanded and contracted, and contracted) in accordance with the deformation of the dielectric elastomer film.

Various considerations have been given to the configuration of this converter. Specifically, a dielectric elastic body (an elastic insulating material portion/ an elastic and high-dielectric material portion/ an elastic insulating material portion) is disposed between the two electrodes (for example, see PTL 1) in order to increase an amount of displacement in response to an applied voltage.

### Citation List

### Patent Literature

PTL 1: Japanese Unexamined Patent Application Publication No. 2010-068667)

### Summary of the Invention

Further improvement in conversion characteristics of a converter is desired. Therefore, there is still room for improvement regarding a configuration of the converter.

Accordingly, it is desirable to provide a converter that makes it possible to obtain superior conversion characteristics.

As a result of intensive studies to achieve the above-described purpose, the inventors have found that the above-described problem is solved by providing, between an electrode and a dielectric elastomer film, a film having relative dielectric constant that is higher than relative dielectric constant of the dielectric elastomer film.

The invention is made on the basis of the above-described findings. A converter according to one embodiment of the invention includes a first electrode, a second electrode, a dielectric elastomer film, and a high-dielectric-constant film. The dielectric elastomer film is disposed between the first electrode and the second electrode, and has relative dielectric constant ε1. The high-dielectric-constant film is disposed at one or both of: a location between the first electrode and the dielectric elastomer film; and a location between the second electrode and the dielectric elastomer film. The high-dielectric-constant film has relative dielectric constant ε2 that is higher than the relative dielectric constant ε1.

A configuration of the converter according to one embodiment of the invention encompasses the following three modes. Firstly, the converter may include the high-dielectric-constant film between the first electrode and the dielectric elastomer film, and may not include the high-dielectric-constant film between the second electrode and the dielectric elastomer film. Secondly, the converter may not include the high-dielectric-constant film between the first electrode and the dielectric elastomer film, and may include the high-dielectric-constant film between the second electrode and the dielectric elastomer film. Thirdly, the converter may include the high-dielectric-constant film between the first electrode and the dielectric elastomer film, and also include the high-dielectric-constant film between the second electrode and the dielectric elastomer film.

According to the converter of one embodiment of the invention, the high-dielectric-constant film is disposed at one or both of: the location between the first electrode and the dielectric elastomer film; and the location between the second electrode and the dielectric elastomer film, and the high-dielectric-constant film has the relative dielectric constant ε2 that is higher than the relative dielectric constant ε1. Hence, it is possible to obtain superior conversion characteristics.

### Brief Description of Drawings

[FIG. 1] FIG. 1 is a cross-sectional view of basic configuration 1 of a converter according to an embodiment of the invention.
[FIG. 2] FIG. 2 is a cross-sectional view of basic configuration 2 of the converter according to an embodiment of the invention.
[FIG. 3] FIG. 3 is a cross-sectional view of basic configuration 3 of the converter according to an embodiment of the invention.
[FIG. 4] FIG. 4 is a cross-sectional view of a specific configuration (configuration example 1 to which the basic configuration 1 is applied) of the converter.
[FIG. 5] FIG. 5 is a cross-sectional view of a specific configuration (configuration example 1 to which the basic configuration 2 is applied) of the converter.
[FIG. 6] FIG. 6 is a cross-sectional view of a specific configuration (configuration example 1 to which the basic configuration 3 is applied) of the converter.
[FIG. 7] FIG. 7 is a cross-sectional view of a specific configuration (configuration example 2 to which the basic configuration 1 is applied) of the converter.
[FIG. 8] FIG. 8 is a cross-sectional view of a specific configuration (configuration example 2 to which the basic configuration 2 is applied) of the converter.
[FIG. 9] FIG. 9 is a cross-sectional view of a specific configuration (configuration example 2 to which the basic configuration 3 is applied) of the converter.
[FIG. 10] FIG. 10 is a cross-sectional view of a configuration of a converter according to a comparative example.
[FIG. 11] FIG. 11 is a cross-sectional view of a modification example regarding a configuration of the converter.
[FIG. 12] FIG. 12 is a cross-sectional view of another modification example regarding the configuration of the converter.

### Modes for Carrying Out the Invention

An embodiment of the invention is described in detail below. The description is given in the following order. It is to be noted that the details regarding the invention are not limited to embodiments described below, and are modifiable as appropriate.

1. Converter
   1-1. Basic Configuration
   1-2. Specific Configuration Example 1
   1-3. Specific Configuration Example 2
   1-4. Operation
   1-5. Manufacturing Method
   1-6. Workings and Effects
   1-7. Modification Examples
2. Applications of Converter
   2-1. Mechanical Device
   2-2. Electric Device
   2-3. Detecting Device

### [1. Converter]

A description is given first of a converter according to an embodiment of the invention.

The converter described here is a device that performs conversion of a physical quantity by the use of a dielectric elastomer film, which is a so-called dielectric transducer.

A type of the physical quantity converted by the converter is not particularly limited, and is, for example, one or more types of any physical quantities. Examples of the physical quantity include electric energy, mechanical energy, etc.

An application of the converter is determined, for example, in accordance with the type of the physical quantity before conversion, the type of the physical quantity after the conversion, etc. Specific applications of the converter will be described later.

### [1-1. Basic Configuration]

The converter has a basic configuration as described below.

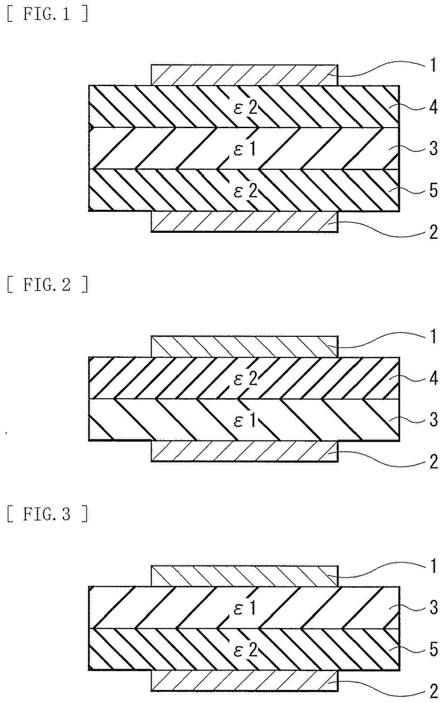

FIG. 1 illustrates a cross-sectional configuration (basic configuration 1) of the converter. The converter includes, for example, a first electrode 1, a second electrode 2, a dielectric elastomer film 3, a first high-dielectric-constant film 4, and a second high-dielectric-constant film 5, as illustrated in FIG. 1.

It is to be noted that a planar shape of each of the first electrode 1, the second electrode 2, the dielectric elastomer film 3, the first high-dielectric-constant film 4, and the second high-dielectric-constant film 5 is not particularly limited. In other words, its planar shape may be a circle, a rectangle, or any other shape.

### [First Electrode and Second Electrode]

The first electrode 1 and the second electrode 2 face each other with the dielectric elastomer film 3 in between. A material included in each of the first electrode 1 and the second electrode 2 is not particularly limited. Specifically, each of the first electrode 1 and the second electrode 2 includes, for example, one or more types of electrically-conductive materials such as a carbon material, an electrically-conductive polymer compound, or a metal material. Examples of the carbon material include graphite, fullerene, carbon nanotube (CNT), graphene, etc. The carbon material may be subjected to, for example, one or more of processes such as a metal doping process, a metal encapsulating process, or a metal plating process. Examples of the electrically-conductive polymer compound include polyacetylene, polythiophene, polypyrrole, polyphenylene, polyphenylene vinylene, polybenzothiazole, etc. Examples of the metal material include silver (Ag), gold (Au), aluminum (Al), etc., and the metal material may be an alloy. It is to be noted that the material included in the first electrode 1 and the material included in the second electrode 2 may be the same as each other or different from each other.

It is preferable that each of the first electrode 1 and the second electrode 2 be deformable in accordance with the deformation (expansion and contraction) of the dielectric elastomer film 3 in order to allow for easy execution of an operation (deformation of the dielectric elastomer film 3) of the converter which will be described later. In other words, it is preferable that each of the first electrode 1 and the second electrode 2 have so-called flexibility (expansion and contraction characteristics).

A thickness of each of the first electrode 1 and the second electrode 2 is not particularly limited. The thickness of each of the first electrode 1 and the second electrode 2 is determined, for example, in accordance with the application of the converter, etc. Further, each of the first electrode 1 and the second electrode 2 may be a single layer or a multi-layer.

The first electrode 1 is disposed adjacent to the first high-dielectric-constant film 4, for example. Here, the first electrode 1 is disposed adjacent to part of a surface of the first high-dielectric-constant film 4, for example.

Similarly, the second electrode 2 is disposed adjacent to the second high-dielectric-constant film 5, for example. Here, the second electrode 2 is disposed adjacent to part of a surface of the second high-dielectric-constant film 5, for example.

### [Dielectric Elastomer Film]

The dielectric elastomer film 3 is disposed between the first electrode 1 and the second electrode 2, and has relative dielectric constant ε1.

A value of the relative dielectric constant ε1 is not particularly limited. In particular, it is preferable that the relative dielectric constant ε1 satisfy 1.1 <ε1 ≤130, and it is more preferable that the relative dielectric constant ε1 satisfy 1.8 <ε1 ≤100.

The dielectric elastomer film 3 includes one or more types of elastomers (polymer compounds having rubber-like elasticity). A type of the elastomer is not particularly limited; however, examples of the type of the elastomer include a thermoset elastomer, a thermoplastic elastomer, an energy-ray curable elastomer, etc.

A type of the thermoset elastomer is not particularly limited; however, examples of the type of the thermoset elastomer include natural rubber, synthetic rubber, a silicone-rubber-based elastomer, a urethane-rubber-based elastomer, a fluoro-rubber-based elastomer, etc.

A type of the thermoplastic elastomer is not particularly limited; however, examples of the type of the thermoplastic elastomer include a styrene-based elastomer, an olefin-based elastomer, a vinyl-chloride-based elastomer, a urethane-based elastomer, an amide-based elastomer, an ester-based elastomer, etc. Examples of the vinyl-chloride-based elastomer include polyvinyl chloride (PVC), etc.

The energy-ray curable elastomer is an elastomer that is curable by one or more types of any energy rays. A type of the energy ray is not particularly limited; however, examples of the type of the energy ray include radio waves, a ultra-violet ray, a visible light ray, an infrared ray, etc. More specific examples of the type of the energy ray include an electromagnetic energy ray, a high-energy ray, etc. Examples of a light source of light (wavelength = from 200 nm to 700 nm) of the energy ray include a ultrahigh-pressure mercury lamp, a high-pressure mercury lamp, a medium-pressure mercury lamp, a low-pressure mercury lamp, a mercury-vapor arc light, a xenon arc light, a carbon arc light, a metal-halide lamp, a fluorescent light, a tungsten lamp, an excimer lamp, a germicidal light, a light-emitting diode, a CRT light source, etc. In particular, the light source such as the ultrahigh-pressure mercury lamp, the mercury-vapor arc light, the carbon arc light, the xenon arc light, that generate light having a wavelength from 300 nm to 450 nm is preferable. A frequency band of the radio waves is, for example, a frequency band that is defined by Radio Law as an industry science medical (ISM) band, 915 MHz that is used in a region such as the United States or Europe, etc. Examples of the high-energy ray include an electron ray, an X-ray, radiation, etc.

It is to be noted that the dielectric elastomer film 3 may include one or more types of other materials together with the above-described elastomer. Examples of the other materials include various additives, etc.

A thickness of the dielectric elastomer film 3 is not particularly limited. The thickness of the dielectric elastomer film 3 is determined, for example, in accordance with the application of the converter, etc. Further, the dielectric elastomer film 3 may be a single layer or a multi-layer.

### [First High-dielectric-constant Film and Second High-dielectric-constant Film]

The first high-dielectric-constant film 4 is disposed between the first electrode 1 and the dielectric elastomer film 3, and has relative dielectric constant ε2 that is higher than the relative dielectric constant ε1. The first high-dielectric-constant film 4 is disposed adjacent to each of the first electrode 1 and the dielectric elastomer film 3, for example.

A value of the relative dielectric constant ε2 is not particularly limited. In particular, it is preferable that the relative dielectric constant ε2 satisfy 1.1 <ε2≤ 5000, and it is more preferable that the relative dielectric constant ε2 satisfy 1.8< ε2≤ 5000.

A configuration of the first high-dielectric-constant film 4 is not particularly limited as long as the first high-dielectric-constant film 4 has the relative dielectric constant ε2 that is higher than the relative dielectric constant ε1 as described above. Specifically, the first high-dielectric-constant film 4 includes one or more types of highly-dielectric materials in order to have the relative dielectric constant ε2. A specific configuration of the first high-dielectric-constant film 4 (details of the highly-dielectric material) will be described later.

The second high-dielectric-constant film 5 is disposed between the second electrode 2 and the dielectric elastomer film 3, and has relative dielectric constant ε2 that is higher than the relative dielectric constant ε1. It is to be noted that the value of the relative dielectric constant ε2 of the first high-dielectric-constant film 4 and a value of the relative dielectric constant ε2 of the second high-dielectric-constant film 5 may be the same as each other or different from each other. The second high-dielectric-constant film 5 is disposed adjacent to each of the second electrode 2 and the dielectric elastomer film 3, for example.

A configuration of the second high-dielectric-constant film 5 is not particularly limited as long as the second high-dielectric-constant film 5 has the relative dielectric constant ε2 that is higher than the relative dielectric constant ε1 as described above. Details of the configuration of the second high-dielectric-constant film 5 are similar to those of the first high-dielectric-constant film 4, for example. It is to be noted that the configuration of the first high-dielectric-constant film 4 and the configuration of the second high-dielectric-constant film 5 may be the same as each other or different from each other. A specific configuration of the second high-dielectric-constant film 5 will be described later.

A thickness of each of the first high-dielectric-constant film 4 and the second high-dielectric-constant film 5 is not particularly limited. The thickness of each of the first high-dielectric-constant film 4 and the second high-dielectric-constant film 5 is determined, for example, in accordance with the application of the converter, etc. Further, each of the first high-dielectric-constant film 4 and the second high-dielectric-constant film 5 may be a single layer or a multi-layer.

The converter may include only one of the first high-dielectric-constant film 4 and the second high-dielectric-constant film 5, or include both of the first high-dielectric-constant film 4 and the second high-dielectric-constant film 5. FIG. 1 illustrates an example case where the converter includes both of the first high-dielectric-constant film 4 and the second high-dielectric-constant film 5.

Other than this, for example, the converter may include only the first high-dielectric-constant film 4 without including the second high-dielectric-constant film 5, as illustrated in FIG. 2 (basic configuration 2) corresponding to FIG. 1. In this case, the second high-dielectric-constant film 5 is not disposed between the second electrode 2 and the dielectric elastomer film 3. Therefore, the second electrode 2 is disposed adjacent to the dielectric elastomer film 3. It is to be noted that the converter illustrated in FIG. 2 has a configuration similar to that of the converter illustrated in FIG. 1 except that the converter illustrated in FIG. 2 does not include the second high-dielectric-constant film 5.

Alternatively, for example, the converter may include only the second high-dielectric-constant film 5 without including the first high-dielectric-constant film 4, as illustrated in FIG. 3 (basic configuration 3) corresponding to FIG. 1. In this case, the first high-dielectric-constant film 4 is not disposed between the first electrode 1 and the dielectric elastomer film 3. Therefore, the first electrode 1 is disposed adjacent to the dielectric elastomer film 3. It is to be noted that the converter illustrated in FIG. 3 has a configuration similar to that of the converter illustrated in FIG. 1 except that the converter illustrated in FIG. 3 does not include the first high-dielectric-constant film 4.

In order to specify the relative dielectric constant ε1 of the dielectric elastomer film 3, for example, after the dielectric elastomer film 3 is taken out of the converter by dismantling the converter, the dielectric constant ε1 of the dielectric elastomer film 3 is measured by the use of a dielectric constant measuring system mounted with a LCR meter, etc. The relative dielectric constant ε1 (= ε/ ε0 where ε0 is dielectric constant of vacuum and approximately 1) is thereby calculated. A procedure of specifying each of the relative dielectric constant ε2 of the first high-dielectric-constant film 4 and the relative dielectric constant ε2 of the second high-dielectric-constant film 5 is, for example, similar to the above-described procedure of specifying the relative dielectric constant ε1 of the dielectric elastomer film 3 except that the corresponding one of the first high-dielectric-constant film 4 and the second high-dielectric-constant film 5 is used in place of the dielectric elastomer film 3.

Here, a specific configuration of the converter described above is, for example, as follows. The series of components of the converters illustrated in FIGs. 1 to 3 are referred to below where appropriate.

### [1-2. Specific Configuration Example 1]

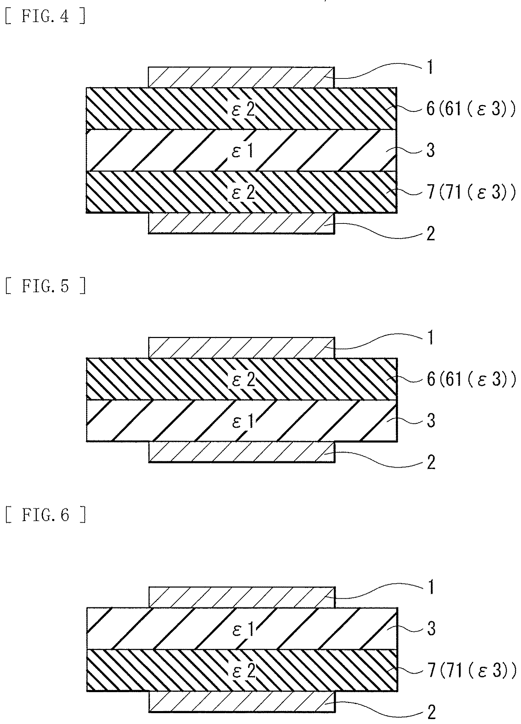

FIG. 4 illustrates a specific cross-sectional configuration (configuration example 1 to which the basic configuration 1 is applied) of the converter, and corresponds to FIG. 1. This converter has a configuration similar to that of the converter illustrated in FIG. 1 except that this converter includes a first high-dielectric-constant film 6 corresponding to the first high-dielectric-constant film 4 and a second high-dielectric-constant film 7 corresponding to the second high-dielectric-constant film 5, for example.

The first high-dielectric-constant film 6 disposed between the first electrode 1 and the dielectric elastomer film 3 has the relative dielectric constant ε2 in order to function as the first high-dielectric-constant film 4.

The first high-dielectric-constant film 6 includes, for example, an elastomer 61 in order to have the relative dielectric constant ε2. The elastomer 61 is the highly-dielectric material described above, and has relative dielectric constant ε3 that is higher than the relative dielectric constant ε1.

Details regarding a value of the relative dielectric constant ε3 are similar to the details regarding the value of the relative dielectric constant ε1 described above.

A type of the elastomer 61 is similar to the material (the elastomer) included in the dielectric elastomer film 3 except that the elastomer 61 has the relative dielectric constant ε3.

The second high-dielectric-constant film 7 disposed between the second electrode 2 and the dielectric elastomer film 3 has the relative dielectric constant ε2 in order to function as the second high-dielectric-constant film 5.

The second high-dielectric-constant film 7 includes, for example, an elastomer 71 in order to have the relative dielectric constant ε2. The elastomer 71 is the highly-dielectric material described above, and has relative dielectric constant ε3 that is higher than the relative dielectric constant ε1. It is to be noted that a value of the relative dielectric constant ε3 of the elastomer 61 and a value of the relative dielectric constant ε3 of the elastomer 71 may be the same as each other or different from each other.

A type of the elastomer 71 is similar to the material (the elastomer) included in the dielectric elastomer film 3 except that the elastomer 71 has the relative dielectric constant ε3. It is to be noted that the type of the elastomer 61 and the type of the elastomer 71 may be the same as each other or different from each other.

Other than this, for example, the converter may include only the first high-dielectric-constant film 6 without including the second high-dielectric-constant film 7, as illustrated in FIG. 5 (the configuration example 1 to which the basic configuration 2 is applied) corresponding to FIG. 2. In this case, the second high-dielectric-constant film 7 is not disposed between the second electrode 2 and the dielectric elastomer film 3. Therefore, the second electrode 2 is disposed adjacent to the dielectric elastomer film 3. It is to be noted that the converter illustrated in FIG. 5 has a configuration similar to that of the converter illustrated in FIG. 4 except that the converter illustrated in FIG. 5 does not include the second high-dielectric-constant film 7.

Alternatively, for example, the converter may include only the second high-dielectric-constant film 7 without including the first high-dielectric-constant film 6, as illustrated in FIG. 6 (the configuration example 1 to which the basic configuration 3 is applied) corresponding to FIG. 3. In this case, the first high-dielectric-constant film 6 is not disposed between the first electrode 1 and the dielectric elastomer film 3. Therefore, the first electrode 1 is disposed adjacent to the dielectric elastomer film 3. It is to be noted that the converter illustrated in FIG. 6 has a configuration similar to that of the converter illustrated in FIG. 4 except that the converter illustrated in FIG. 6 does not include the first high-dielectric-constant film 6.

### [1-3. Specific Configuration Example 2]

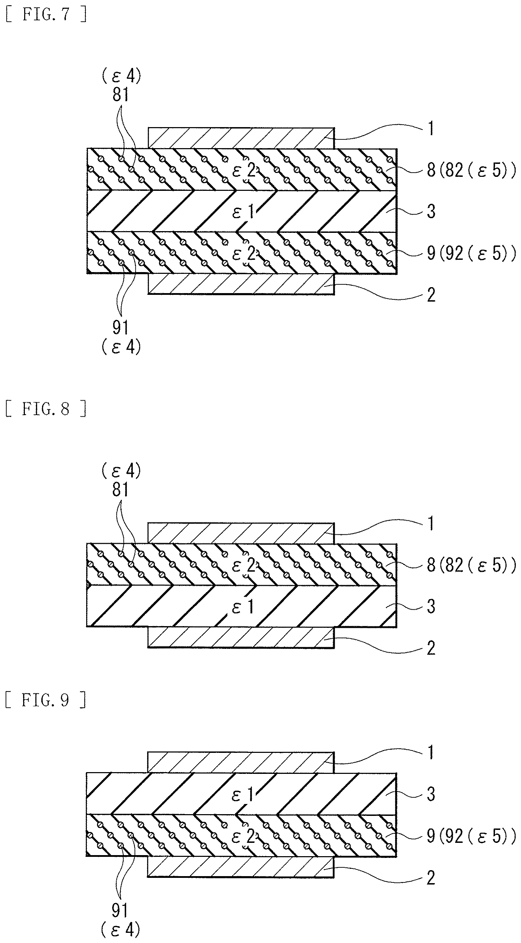

FIG. 7 illustrates a specific cross-sectional configuration (configuration example 2 to which the basic configuration 1 is applied) of the converter, and corresponds to FIG. 1. This converter has a configuration similar to that of the converter illustrated in FIG. 1 except that this converter includes a first high-dielectric-constant film 8 corresponding to the first high-dielectric-constant film 4 and a second high-dielectric-constant film 9 corresponding to the second high-dielectric-constant film 5, for example.

The first high-dielectric-constant film 8 disposed between the first electrode 1 and the dielectric elastomer film 3 has the relative dielectric constant ε2 in order to function as the first high-dielectric-constant film 4.

The first high-dielectric-constant film 8 includes, for example, a plurality of particles 81 and an elastomer 82 in order to have the relative dielectric constant ε2. The plurality of particles 81 are dispersed in the elastomer 82. A content of the plurality of particles 81 in the first high-dielectric-constant film 8 is not particularly limited.

The plurality of particles 81 are the highly-dielectric material described above, and have relative dielectric constant ε4 that is higher than the relative dielectric constant ε1.

A value of the relative dielectric constant ε4 is not particularly limited. In particular, it is preferable that the relative dielectric constant ε4 satisfy 1.1< ε4≤ 5000, and it is more preferable that the relative dielectric constant ε4 satisfy 1.4< ε4≤ 5000.

A type of the plurality of particles 81 is not particularly limited as long as the plurality of particles 81 include one or more types of an inorganic material, etc. having the relative dielectric constant ε4.

A type of the inorganic material is not particularly limited. The inorganic material includes a ceramic material, for example. Examples of the ceramic material include a metal oxide particle having a perovskite crystal structure, a ferroelectric particle having a bismuth-layer structure, etc. Examples of the metal oxide particle include silicon oxide, aluminum oxide, zinc oxide, iron oxide, titanium oxide, barium titanate, strontium titanate, lead titanate, lead zirconate titanate (PZT), bismuth titanate, sodium bismuth titanate, strontium bismuthate tantalate, lanthanum bismuthate titanate, potassium niobite, derivatives thereof, etc. Other than this, the inorganic material may include a carbon material, for example. Examples of the carbon material include graphite, fullerene, carbon nanotube (CNT), graphene, derivatives thereof, etc.

In particular, it is preferable that the ceramic material be one or both of barium titanate and a derivative thereof. A reason for this is that the high relative dielectric constant ε4 is obtained thereby.

Examples of the barium titanate include barium titanate (barium dititanate: BaTi₂O₅), barium titanate (BaTiO₃), reduced products of these types of barium titanate, etc.

The derivative of barium titanate is, for example, a compound in which a metal atom of part of barium titanate is substituted by another metal atom. The "part of barium titanate" is part of barium (Ba) as an A site or part of titanium (Ti) as a B site, or may be part of each of barium and titanium. The "another metal atom" is a metal atom other than titanium and barium. Examples of the "another metal atom" include strontium (St), calcium (Ca), yttrium (Y), neodymium (Nd), samarium (Sm), dysprosium (Dy), vanadium (V), chromium (Cr), manganese (Mn), iron (Fe), cobalt (Co), nickel (Ni), germanium (Ge), selenium (Se), zirconium (Zr), niobium (Nb), molybdenum (Mo), technetium (Tc), ruthenium (Ru), rhodium (Rh), palladium (Pd), tin (Sn), hafnium (Hf), tantalum (Ta), tungsten (W), rhenium (Re), osmium (Os), iridium (Ir), platinum (Pt), etc.

The derivative of each of graphite, fullerene, and carbon nanotube is, for example, a material as a result of performing one or more of processes such as a metal doping process, a metal encapsulating process, or a metal plating process on each of graphite, fullerene, and carbon nanotube, etc.

The elastomer 82 has relative dielectric constant ε5, and a value of the relative dielectric constant ε5 is not particularly limited. In other words, the value of the relative dielectric constant ε5 may be smaller than the value of the relative dielectric constant ε1, higher than the value of the relative dielectric constant ε1, or the same as the value of the relative dielectric constant ε1. It is preferable, however, that the value of the relative dielectric constant ε5 be greater than the value of the relative dielectric constant ε1.

The value of the relative dielectric constant ε5 is not particularly limited. In particular, it is preferable that the relative dielectric constant ε5 satisfy 1.1< ε1≤ 130, and it is more preferable that the relative dielectric constant ε5 satisfy 1.8< ε1≤ 100.

A type of the elastomer 82 is similar to the material (the elastomer) included in the dielectric elastomer film 3 except that the elastomer 82 has the relative dielectric constant ε5.

The second high-dielectric-constant film 9 disposed between the second electrode 2 and the dielectric elastomer film 3 has the relative dielectric constant ε2 in order to function as the second high-dielectric-constant film 5.

This second high-dielectric-constant film 9 includes, for example, a plurality of particles 91 and an elastomer 92 in order to have the relative dielectric constant ε2. The plurality of particles 91 are dispersed in the elastomer 92. A content of the plurality of particles 91 in the second high-dielectric-constant film 9 is not particularly limited.

The plurality of particles 91 are the highly-dielectric material described above, and have relative dielectric constant 4 that is higher than the relative dielectric constant ε1. It is to be noted that the value of the relative dielectric constant ε4 of the plurality of particles 81 and the value of the relative dielectric constant ε4 of the plurality of particles 91 may be the same as each other or different from each other.

A type of the plurality of particles 91 is not particularly limited as long as the plurality of particles 91 include one or more types of the inorganic materials having the relative dielectric constant ε4. Details regarding the inorganic materials are as described above. It is to be noted that the type of the inorganic material included in the plurality of particles 81 and the type of the inorganic material included in the plurality of particles 91 may be the same as each other or different from each other.

The elastomer 92 has the relative dielectric constant ε5, and a value of the relative dielectric constant ε5 is not particularly limited. Details regarding the value of the relative dielectric constant ε5 are as described above, for example. It is to be noted that the value of the relative dielectric constant ε5 of the elastomer 82 and the value of the relative dielectric constant ε5 of the elastomer 92 may be the same as each other or different from each other. Further, a type of the elastomer 92 is similar to that of the material (the elastomer) included in the dielectric elastomer film 3 except that the elastomer 92 has the relative dielectric constant ε5. It is to be noted that the type of the elastomer 82 and the type of the elastomer 92 may be the same as each other or different from each other.

Other than this, for example, the converter may include only the first high-dielectric-constant film 8 without including the second high-dielectric-constant film 9, as illustrated in FIG. 8 (the configuration example 2 to which the basic configuration 2 is applied) corresponding to FIG. 2. In this case, the second high-dielectric-constant film 9 is not disposed between the second electrode 2 and the dielectric elastomer film 3. Therefore, the second electrode 2 is disposed adjacent to the dielectric elastomer film 3. It is to be noted that the converter illustrated in FIG. 8 has a configuration similar to that of the converter illustrated in FIG. 7 except that the converter illustrated in FIG. 8 does not include the second high-dielectric-constant film 9.

Alternatively, for example, the converter may include only the second high-dielectric-constant film 9 without including the first high-dielectric-constant film 8, as illustrated in FIG. 9 (the configuration example 2 to which the basic configuration 3 is applied) corresponding to FIG. 3. In this case, the first high-dielectric-constant film 8 is not disposed between the first electrode 1 and the dielectric elastomer film 3. Therefore, the first electrode 1 is disposed adjacent to the dielectric elastomer film 3. It is to be noted that the converter illustrated in FIG. 9 has a configuration similar to that of the converter illustrated in FIG. 7 except that the converter illustrated in FIG. 9 does not include the first high-dielectric-constant film 8.

### [1-4. Operation]

The converter operates as follows, for example.

When a voltage is applied between the first electrode 1 and the second electrode 2, attraction and repulsion are generated between electrically-charged particles as a result of electrostatic force. Specifically, the electrically-charged particles repel each other inside the first electrode 1 and the electrically-charged particles repel each other inside the second electrode 2. Further, the electrically-charged particle inside the first electrode 1 and the electrically-charged particle inside the second electrode 2 attract each other. This deforms the dielectric elastomer film 3. In this case, the dielectric elastomer film 3 contracts in a thickness direction, and expands in a surface direction. Thereafter, when the application of the voltage is halted, the dielectric elastomer film 3 returns to a state before the application of the voltage. In this case, the dielectric elastomer film 3 expands in the thickness direction and contracts in the surface direction. It is to be noted that, in a case where the dielectric elastomer film 3 is deformed, each of the first electrode 1 and the second electrode 2 is also deformed in accordance with the deformation of the dielectric elastomer film 3.

Accordingly, when electric energy (the voltage) is supplied to the converter, the electric energy is converted into mechanical energy (an expansion and contraction movement) by the converter.

It is to be noted that, in FIGs. 1 to 9, the "thickness direction" is a direction in which the first electrode 1 and the second electrode 2 face each other (a top-bottom direction), and the "surface direction" is a direction intersecting the above-described thickness direction (a right-left direction).

Moreover, the converter has a configuration in which the dielectric elastomer film 3 is disposed between the flexible first electrode 1 and the flexible second electrode 2. Therefore, the converter is regarded as a kind of a variable capacitor whose electrostatic capacitance is variable in accordance with external force (mechanical energy supplied from outside). It is to be noted that a volume of the variable capacitor is constant when the electrostatic capacitance is varied.

In the converter, when the external force is supplied, the dielectric elastomer film 3 is deformed in response to the external force. In this case, the dielectric elastomer film 3 contracts in the thickness direction and expands in the surface direction, which reduces the thickness of the dielectric elastomer film 3. Accordingly, the area of each of the first electrode 1 and the second electrode 2 is increased. Therefore, the converter is placed into a high capacitance state. Thereafter, when the supply of the external force is halted, the dielectric elastomer film 3 returns, as a result of elasticity of the dielectric elastomer film 3 itself, to a state before the external force is supplied. In this case, the dielectric elastomer film 3 expands in the thickness direction and contracts in the surface direction, which increases the thickness of the dielectric elastomer film 3. Accordingly, the area of each of the first electrode 1 and the second electrode 2 is reduced. Therefore, the converter is placed into a low capacitance state. Such variation in electric charge increases the potential difference. Therefore, the electrostatic energy is increased.

Thus, when the mechanical energy (the external force) is supplied to the converter, the mechanical energy is converted into electric energy (electrostatic energy) by the converter.

Moreover, when external force having any physical quantity is supplied to the converter, the dielectric elastomer film 3 is deformed in response to the external force. Therefore, electrostatic capacitance (electric energy) between the first electrode 1 and the second electrode 2 is varied. On the basis of this variation in electrostatic capacitance, the supply of the external force to the converter is detected and a value of the external force (a physical quantity) is specified.

Thus, when the external force having any physical quantity is supplied, the supply of the external force, etc. are detected by the converter on the basis of the variation in electrostatic capacitance.

More specifically, the converter described here exhibits various functions in accordance with the application of the converter by utilizing the above-described conversion of physical quantity. Details of the functions of the converter will be described later together with the application of the converter.

### [1-5. Manufacturing Method]

Next, a description is given of a method of manufacturing the converter.

The converter is manufactured by the following procedure, for example. It is to be noted that the following description refers to, as an example, a case where the converter illustrated in FIG. 1 is manufactured. Further, as the materials included in the series of components of the converter, etc. have been already described in detail, the description thereof is omitted below.

### [Preparation of Dielectric Elastomer Film]

First, the dielectric elastomer film 3 having the relative dielectric constant ε1 is prepared. The dielectric elastomer film 3 has a pair of surfaces that face each other. The "pair of surfaces" are one surface (a top surface) and the other surface (a bottom surface). It is to be noted that the procedure of forming the dielectric elastomer film 3 is as follows, for example.

In a case where the thermoset elastomer is used as the material of forming the dielectric elastomer film 3, for example, a paste including the thermoset (uncured) elastomer, a curing catalyst, a diluting solvent provided on an as-needed basis, etc. are mixed, and the mixture is stirred. Thereby, a mixed solution (for example, slurry) is obtained.

A type of the diluting solvent is not particularly limited; however, the diluting solvent is, for example, one or more types of organic solvents such as toluene, cyclohexane, xylene, tetrahydrofuran, chloroform, methyl ethyl ketone, or methyl isobutyl ketone. The details regarding the diluting solvent are similarly applicable to a description below.

Thereafter, after the mixed solution is applied to one surface of a supporting film, the applied mixed solution is dried by heating to thereby allow for a reaction (thermosetting) of the thermoset elastomer. In a case where the mixed solution is applied, for example, one or more types of coating devices such as a bar coater, a die coater, a curtain coater, a roll coater, or a spin coater are used. Other than this, for example, various printing methods may be used, or a dipping method may be used, to apply the mixed solution. The details regarding the method of applying the mixed solution are similarly applicable to a description below. A type of the supporting film is not particularly limited; however, the supporting film is, for example, a plastic film such as polyethylene terephthalate. A cured product of the thermoset elastomer is thereby shaped into a sheet (film) shape. Thereby, the dielectric elastomer film 3 having the relative dielectric constant ε1 is obtained. Thereafter, the supporting film is peeled off from the dielectric elastomer film 3.

In a case where the thermoplastic elastomer is used as the material of forming the dielectric elastomer film 3, for example, a paste including the thermoplastic elastomer, a diluting solvent provided on an as-needed basis, etc. are mixed, and the mixture is stirred. Thereby, a mixed solution is obtained. Thereafter, after the mixed solution is applied to one surface of a supporting film, the applied mixed solution is dried. In this case, the mixed solution may be dried by heating, or the mixed solution may be dried by depressurization. The thermoplastic elastomer is thereby shaped into a sheet (film) shape. Thereby, the dielectric elastomer film 3 having the relative dielectric constant ε1 is obtained. Thereafter, the supporting film is peeled off from the dielectric elastomer film 3.

In a case where the energy-ray-curable elastomer is used as the material of forming the dielectric elastomer film 3, for example, a paste including the energy-ray-curable (uncured) elastomer, a diluting solvent provided on an as-needed basis, etc. are mixed, and the mixture is stirred. Thereby, a mixed solution is obtained. Thereafter, after the mixed solution is applied to one surface of a supporting film, the applied mixed solution is irradiated with an energy ray. A cured product of the energy-ray-curable elastomer is thereby shaped into a sheet (film) shape. Thereby, the dielectric elastomer film 3 having the relative dielectric constant ε1 is obtained. Thereafter, the supporting film is peeled off from the dielectric elastomer film 3.

### [Formation of First High-dielectric-constant Film and Second High-dielectric-constant Film]

Thereafter, the first high-dielectric-constant film 4 having the relative dielectric constant ε2 is formed on one surface of the dielectric elastomer film 3, and the second high-dielectric-constant film 5 having the relative dielectric constant ε2 is formed on the other surface of the dielectric elastomer film 3.

A procedure of forming the first high-dielectric-constant film 6 corresponding to the first high-dielectric-constant film 4 and forming the second high-dielectric-constant film 7 corresponding to the second high-dielectric-constant film 5 in [1-2. Specific Configuration Example 1] described above is, for example, as follows.

In a case of forming the first high-dielectric-constant film 6, for example, a paste including the thermoset elastomer, a curing catalyst, adiluting solvent, etc. are mixed provided on an as-needed basis, and the mixture is stirred. Thereby, a mixed solution is obtained.

Thereafter, after the mixed solution is applied to one surface of the dielectric elastomer film 3, the mixed solution is dried by heating to thereby allow for a reaction (thermosetting) of the thermoset elastomer. Thereby, the elastomer 61 having the relative dielectric constant ε3 is formed. Accordingly, the first high-dielectric-constant film 6 including the elastomer 61 and having the relative dielectric constant ε2 is formed.

In a case of forming the second high-dielectric-constant film 7, for example, a procedure similar to the procedure of forming the first high-dielectric-constant film 6 is used except that the elastomer 71 having the relative dielectric constant ε3 is formed in place of the elastomer 61 having the relative dielectric constant ε3.

In contrast, a procedure of forming the first high-dielectric-constant film 8 corresponding to the first high-dielectric-constant film 4 and forming the second high-dielectric-constant film 9 corresponding to the second high-dielectric-constant film 5 in [1-3. Specific Configuration Example 2] described above is, for example, as follows.

In a case of forming the first high-dielectric-constant film 8, for example, the plurality of particles 81 having the relative dielectric constant ε4, a paste including the thermoset elastomer, a curing catalyst, a diluting solvent provided on an as-needed basis, etc. are mixed, and the mixture is stirred. Thereby, a mixed solution in which the plurality of particles 81 are dispersed in the paste is obtained. Thereafter, after the mixed solution is applied to one surface of the dielectric elastomer film 3, the applied mixed solution is dried by heating to thereby allow for a reaction (thermosetting) of the thermoset elastomer. Thereby, the elastomer 82 having the relative dielectric constant ε5 is formed, and the plurality of particles 81 are dispersed in the elastomer 82. Accordingly, the first high-dielectric-constant film 8 including the plurality of particles 81 and the elastomer 82 and having the relative dielectric constant ε2 is formed. 8 is formed.

In a case of forming the second high-dielectric-constant film 9, for example, a procedure similar to the procedure of forming the first high-dielectric-constant film 8 is used except that the plurality of particles 91 having the relative dielectric constant ε4 are used in place of the plurality of particles 81 having the relative dielectric constant ε4, and the elastomer 92 having the relative dielectric constant ε5 is formed in place of the elastomer 82 having the relative dielectric constant ε5.

### [Formation of First Electrode and Second Electrode]

Lastly, the first electrode 1 is formed on the first high-dielectric-constant film 4 (the first high-dielectric-constant film 6 or the first high-dielectric-constant film 8), and the second electrode 2 is formed on the second high-dielectric-constant film 5 (the second high-dielectric-constant film 7 or the second term dielectric constant film 9).

A method of forming the first electrode 1 is not particularly limited as long as the method allows for formation of the first electrode 1 that is deformable in accordance with the deformation of the dielectric elastomer film 3. Here, for example, in order to form the first electrode 1, an electrically-conductive paste including an electrically-conductive material is applied to a surface of the first high-dielectric-constant film 4 by a method similar to that in the case where the mixed solution is applied in the process of forming the dielectric elastomer film 3. Thereafter, the electrically-conductive paste is dried.

A method of forming the second electrode 2 is not particularly limited as long as the method allows for formation of the second electrode 2 that is deformable in accordance with the deformation of the dielectric elastomer film 3. Here, for example, in order to form the second electrode 2, an electrically-conductive paste including an electrically-conductive material is applied to a surface of the second high-dielectric-constant film 5 by a method similar to that in the case where the mixed solution is applied in the process of forming the dielectric elastomer film 3. Thereafter, the electrically-conductive paste is dried.

Thereby, the converter including the first high-dielectric-constant film 4 and the second high-dielectric-constant film 5 is completed.

It is to be noted that the converter illustrated in each of FIGs. 2 and 3 is manufactured by a procedure similar to the above-described procedure of manufacturing the converter illustrated in FIG. 1, although details thereof are not described here.

In other words, the procedure of manufacturing the converter illustrated in FIG. 2 is, for example, similar to the procedure of manufacturing the converter illustrated in FIG. 1 except that the second high-dielectric-constant film 5 (the second high-dielectric-constant film 7 or the second high-dielectric-constant film 9) is not formed. In this case, the second electrode 2 is formed on the other surface of the dielectric elastomer film 3.

Further, the procedure of manufacturing the converter illustrated in FIG. 3 is, for example, similar to the procedure of manufacturing the converter illustrated in FIG. 1 except that the first high-dielectric-constant film 4 (the first high-dielectric-constant film 6 or the second high-dielectric-constant film 8) is not formed. In this case, the first electrode 1 is formed on one surface of the dielectric elastomer film 3.

### [1-6. Workings and Effects]

According to the converter of an embodiment of the invention, workings and effects described below are obtainable.

### [Main Workings and Main Effects]

As illustrated in FIG. 1, the converter of the invention includes, together with the dielectric elastomer film 3 (the relative dielectric constant ε1), the first high-dielectric-constant film 4 (the relative dielectric constant ε2> ε1) and the second high-dielectric-constant film 5 (the relative dielectric constant ε2> ε1). Accordingly, superior conversion characteristics are obtainable for the following reasons.

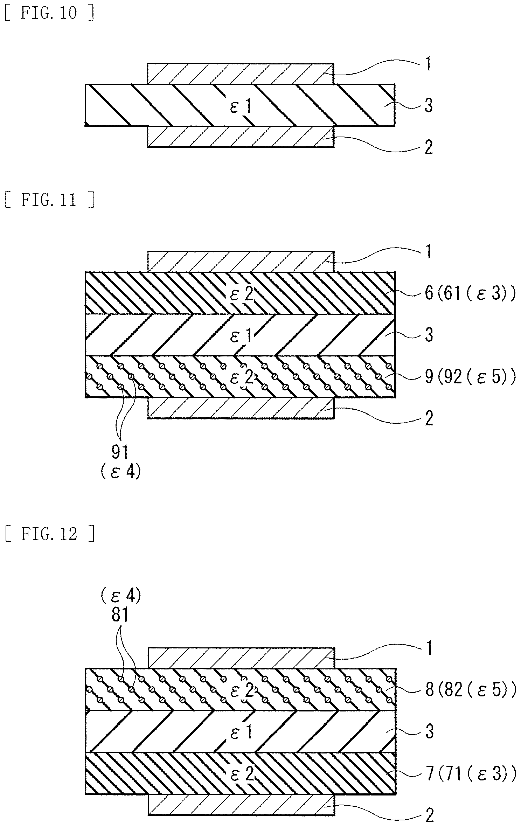

FIG. 10 illustrates a cross-sectional configuration of a converter of a comparative example, and corresponds to FIG. 1. The converter of the comparative example has a configuration similar to that of the converter of the invention except that the converter of the comparative example does not include the first high-dielectric-constant film 4 and the second high-dielectric-constant film 5, and therefore, only the dielectric elastomer film 3 (the relative dielectric constant ε1) is disposed between the first electrode 1 and the second electrode 2.

In order to improve conversion efficiency of the converter of the comparative example, relative dielectric constant of the converter as a whole should be increased by increasing the relative dielectric constant ε1. When the relative dielectric constant ε1 is increased, however, the dielectric elastomer film 3 is hardened. This makes the deformation of the dielectric elastomer film 3 more difficult. Thus, it is difficult to improve the conversion efficiency while ensuring the deformability of the dielectric elastomer film 3. Hence, it is possible to obtain superior conversion characteristics.

In contrast, in order to increase the relative dielectric constant of the converter of the invention as a whole, it is sufficient that the relative dielectric constant ε2 is increased without increasing the relative dielectric constant ε1. The relative dielectric constant of the converter as a whole is thereby increased. Therefore, it becomes easier to improve the conversion efficiency. In addition, when the relative dielectric constant ε2 is increased, decreasing of the relative dielectric constant ε1 makes it more difficult for the dielectric elastomer film 3 to be hardened. It is therefore more difficult for the film, as a whole, that includes the dielectric elastomer film 3, the first high-dielectric-constant film 4, and the second high-dielectric-constant film 5, to be hardened, which allows for easier deformation of the dielectric elastomer film 3. Accordingly, it is possible to improve the conversion efficiency while ensuring the deformability of the dielectric elastomer film 3. Hence, it is possible to obtain superior conversion characteristics.

It is to be noted that the workings and effects regarding the converter of the invention described above are not limited to the case illustrated in FIG. 1, and are similarly obtainable in the case illustrated in each of FIGs. 2 and 3 as well. A reason for this is that, when the converter includes at least one of the first high-dielectric-constant film 4 and the second high-dielectric-constant film 5, it is possible to improve conversion efficiency while ensuring the deformability of the dielectric elastomer film 3 for the reasons described above, unlike the case where the converter includes none of the first high-dielectric-constant film 4 and the second high-dielectric-constant film 5. It is to be noted that a case where the converter includes both of the first high-dielectric-constant film 4 and the second high-dielectric-constant film 5 is more preferable than the case where the converter includes only one of the first high-dielectric-constant film 4 and the second high-dielectric-constant film 5, in order to further improve the conversion efficiency.

In particular, it is possible to sufficiently improve the conversion efficiency while ensuring the deformability of the dielectric elastomer film 3 when one or both of the first high-dielectric-constant film 6 including the elastomer 61 (the relative dielectric constant ε3> ε1) and the second high-dielectric-constant film 7 including the elastomer 71 (the relative dielectric constant ε3> ε1) as illustrated in FIGs. 4 to 6.

Moreover, it is possible to sufficiently improve the conversion efficiency while ensuring the deformability of the dielectric elastomer film 3, when one or both of the first high-dielectric-constant film 8 including the plurality of particles 81 (the relative dielectric constant ε4> ε1) and the elastomer 82 and the second high-dielectric-constant film 9 including the plurality of particles 91 (the relative dielectric constant ε4> ε1) and the elastomer 92 are used, as illustrated in FIGs. 7 to 9.

Other than this, when each of the plurality of particles 81 and the plurality of particles 91 includes one or both of barium titanate and a derivative thereof, the relative dielectric constant ε4 is further increased. Hence, it is possible to obtain higher effects.

### [Other Workings and Other Effects]

It is to be noted that advantages described below are also obtainable according to the converter of the invention.

Firstly, withstand voltage characteristics are improved in the converter of the invention that includes the first high-dielectric-constant film 4 and the second high-dielectric-constant film 5, compared with the converter of the comparative example that does not include the first high-dielectric-constant film 4 or the second high-dielectric-constant film 5. Hence, it is possible to obtain superior conversion characteristics also from this point of view.

Secondly, when a voltage is applied between the first electrode 1 and the second electrode 2 of the converter of the comparative example, a leakage current is easily generated due to the dielectric elastomer film 3. This makes it easier for the conversion efficiency to be decreased. This phenomenon is especially noticeable in a case where a urethane-rubber-based elastomer, etc. are used as the material included in the dielectric elastomer film 3.

In contrast, each of the first high-dielectric-constant film 4 and the second high-dielectric-constant film 5 functions as an electric protective film in the converter of the invention. This makes it more difficult for a leakage current to be generated. Thus, the generation of the leakage current is suppressed by the first high-dielectric-constant film 4 and the second high-dielectric-constant film 5 while the relative dielectric constant of the converter as a whole is increased by utilizing the first high-dielectric-constant film 4 and the second high-dielectric-constant film 5. Hence, it is possible to obtain superior conversion characteristics also from this point of view.

Thirdly, each of the first high-dielectric-constant film 4 and the second high-dielectric-constant film 5 functions as the electric protective film as described above, and also functions as a barrier (a protective film) against moisture.

Specifically, it is easier for moisture to enter inside the converter of the comparative example that does not include the first high-dielectric-constant film 4 or the second high-dielectric-constant film 5. When moisture enters inside the converter, the moisture is adsorbed onto the dielectric elastomer film 3. This makes it easier for the conversion efficiency to be decreased and also makes it easier for the dielectric elastomer film 3 to be degraded.

In contrast, in the converter of the invention including the first high-dielectric-constant film 4 and the second high-dielectric-constant film 5, each of the first high-dielectric-constant film 4 and the second high-dielectric-constant film 5 functions as a barrier against moisture as described above. This makes it more difficult for moisture to enter inside of the converter. Accordingly, it is more difficult for moisture to be adsorbed onto the dielectric elastomer film 3. This makes it more difficult for the conversion efficiency to be decreased and also makes it more difficult for the dielectric elastomer film 3 to be degraded. Hence, it is possible to obtain superior conversion characteristics also from this point of view.

Fourthly, it is able to be considered to allow the dielectric elastomer film 3 (the relative dielectric constant ε1) to be a multi-layer in order to improve the conversion efficiency and prevent entering of moisture in the converter of the comparative example. However, when the dielectric elastomer film 3 is a multi-layer, each layer is polarized. This excessively increases the number of polarized locations. Hence, it is easier for a leakage current to be generated.

In contrast, in the converter of the invention, the use of the first high-dielectric-constant film 4 and the second high-dielectric-constant film 5 makes it possible to improve conversion efficiency and suppress entering of moisture while avoiding an excessive increase in number of polarized locations. Hence, it is possible to obtain superior conversion characteristics also from this point of view.

Fifthly, in the converter of the comparative example, each of the first electrode 1 and the second electrode 2 is disposed adjacent to the dielectric elastomer film 3. In this case, when the electrically-conductive particles of a carbon material, a metal material, etc. are included in the electrically-conductive paste that is a material included in each of the first electrode 1 and the second electrode 2, it is easier for the electrically-conductive particles to come into contact with the dielectric elastomer film 3. This makes it easier for the dielectric elastomer film 3 to be damaged. A reason for this is that, in general, a shape of the electrically-conductive particle is a shape having a sharp corner. Therefore, the dielectric elastomer film 3 is damaged more easily by the electrically-conductive particles in a process of forming each of the first electrode 1 and the second electrode 2 with the use of the electrically-conductive paste including the electrically-conductive particles. The damage to the dielectric elastomer film 3 refers to, for example, partial cutting of the dielectric elastomer film 3, partial removal of the dielectric elastomer film 3, etc. When the dielectric elastomer film 3 that is a main part of the converter is damaged, the first electrode 1 and the second electrode 2 become electrically continuous with each other. This prevents drive of the converter in the first place.

In contrast, in the converter of the invention, the first high-dielectric-constant film 4 is disposed between the first electrode 1 and the dielectric elastomer film 3. Therefore, the first high-dielectric-constant film 4 functions as a physical protective film. Further, the second high-dielectric-constant film 5 is disposed between the second electrode 2 and the dielectric elastomer film 3. Therefore, the second high-dielectric-constant film 5 functions as a physical protective film. In this case, it is more difficult for the electrically-conductive particle included in the electrically-conductive paste to come into contact with the dielectric elastomer film 3. Therefore, it is more difficult for the dielectric elastomer film 3 to be damaged. Accordingly, insulation characteristics between the first electrode 1 and the second electrode 2 are ensured, which prevents the converter from not being able to be driven in the first place and improves lifetime of the converter. Hence, it is possible to obtain superior conversion characteristics also from this point of view.

Sixthly, in the converter of the invention, conversion efficiency is improved as described above. Therefore, for example, in a case where electric energy is converted into mechanical energy, a small amount of electric energy is enough for obtaining a certain amount of mechanical energy. In detail, the amount of electric energy necessary for obtaining a certain amount of mechanical energy is high in a case of low conversion efficiency; however, the amount of electric energy necessary for obtaining a certain amount of mechanical energy is low in a case of high conversion efficiency. Accordingly, it is possible to suppress electric power consumed by the converter. Further, it is possible to increase lifetime of the converter in accordance with the suppression of the electric power consumed by the converter.

### [1-7. Modification Examples]

The configuration of the converter of an embodiment of the invention is modifiable as appropriate.

Specifically, regarding the configuration of the converter of an embodiment of the invention, the basic configurations 1 to 3 have been described with reference to FIGs. 1 to 3, and the specific configuration examples 1 and 2 have been described with reference to FIGs. 4 to 9. However, any combination of the series of the configurations of the converter illustrated in FIGs. 4 to 9 is possible as described below. Similar workings and similar effects are obtainable also in this case.

For example, the configuration example 1 illustrated in FIG. 4 and the configuration example 2 illustrated in FIG. 7 may be combined. In this case, as illustrated in FIG. 11, the converter may include the first high-dielectric-constant film 6 and the second high-dielectric-constant film 9, for example. Alternatively, as illustrated in FIG. 12, the converter may include the first high-dielectric-constant film 8 and the second high-dielectric-constant film 7, for example.

### [2. Applications of Converter]

Next, applications of the converter of an embodiment of the invention are described.

An application of the converter is not particularly limited as long as the converter exhibits a desired function by utilizing the conversion of the physical quantity in the application as described above. The desired function is not particularly limited as long as the function is required in accordance with the application of the converter. It is to be noted that the application of the converter may be an active application or a passive application. Further, only one converter may be used or two or more converters may be used in the application of the converter. In particular, in the latter case, a collective entity such as a conversion system may be structured with two or more converters.

### [2-1. Mechanical Device]

An application of the converter is, for example, a mechanical device that exhibits a particular function by converting electric energy into mechanical energy to thereby utilize the mechanical energy.

A type of the mechanical device is not particularly limited as long as a particular function is exhibited by utilizing mechanical energy. Specifically, examples of the mechanical device include an actuator, a speaker, an in-liquid microphone, etc. Examples of the actuator include artificial muscle, a robot, a solenoid, etc.

The mechanical device exhibits a mechanical function by utilizing the above-described operation of the converter, i.e., the operation of converting electric energy into mechanical energy.

Specifically, when a voltage is applied between the first electrode 1 and the second electrode 2, the dielectric elastomer film 3 is deformed by utilizing electrostatic force. In this case, the dielectric elastomer film 3 contracts in the thickness direction, and expands in the surface direction. Thereafter, when the above-described application of the voltage is halted, the dielectric elastomer film 3 is deformed again by utilizing elasticity of the dielectric elastomer film 3 itself. In this case, the dielectric elastomer film 3 expands in the thickness direction, and contracts in the surface direction. Therefore, the dielectric elastomer film 3 returns to a state before the voltage is supplied.

Hence, it is possible for the mechanical device to execute various operations such as a protruding operation, a recessing operation, a reciprocating (vibrating) operation, or a rotating operation, by utilizing the above-described deformation of the dielectric elastomer film 3.

### [2-2. Electric Device]

Moreover, an application of the converter is, for example, an electric device that exhibits a particular function by converting mechanical energy into electric energy to thereby utilize the electric energy.

A type of the electric device is not particularly limited as long as a particular function is exhibited by utilizing electric energy. Specifically, examples of the electric device include an electric generator, etc.

The electric device exhibits an electric function by utilizing the above-described operation of the converter, i.e., the operation of converting mechanical energy into electric energy.

Specifically, when external force is supplied to the electric device, the dielectric elastomer film 3 is deformed in response to the external force. In this case, the dielectric elastomer film 3 expands in the surface direction, and contracts in the thickness direction. This generates electric charges in the dielectric elastomer film 3 and the electric charges are stored in the dielectric elastomer film 3. Thereafter, when the above-described supply of the external force is halted, the dielectric elastomer film 3 is deformed again by utilizing elasticity of the dielectric elastomer film 3 itself. In this case, the dielectric elastomer film 3 contracts in the surface direction, and expands in the thickness direction. This forces the electric charges to be moved from the dielectric elastomer film 3 toward the first electrode 1 and the second electrode 2, and a potential difference (electrostatic energy) is thereby generated between the first electrode 1 and the second electrode 2. Repeating of the deformation and re-deformation of the dielectric elastomer film 3 increases electrostatic energy.

Hence, it is possible for the electric device to execute various operations such as an electric power generating operation, by utilizing the above-described deformation of the dielectric elastomer film 3.

### [2-3. Detecting Device]

Moreover, an application of the converter is, for example, a detecting device that converts a physical quantity such as pressure into electric energy to thereby detect the physical quantity (including measurement) on the basis of variation in the electric energy.

A type of the detecting device is not particularly limited as long as the device detects a physical quantity on the basis of variation in electrostatic capacitance or in electric signal that uses the electrostatic capacitance. Specifically, examples of the detecting device include a pressure sensor, a position sensor, a vibration sensor, etc.

The detecting device exhibits a detecting function by utilizing the above-described operation of the converter, i.e., the operation of converting the physical quantity such as pressure into electrostatic capacitance.

Specifically, when external force having any physical quantity is supplied to the detecting device, the dielectric elastomer film 3 is deformed in response to the external force. This varies electrostatic capacitance between the first electrode 1 and the second electrode 2. On the basis of this variation in electrostatic capacitance, the supply of the external force to the detecting device is detected, and a value of the external force (the physical quantity) is specified.

Hence, it is possible for the detecting device to execute the detecting operation by utilizing the above-described deformation of the dielectric elastomer film 3.

It is to be noted that a size of the converter is not particularly limited. It is possible to design the converter with any size in accordance with the application of the converter, etc., for example. It goes without saying that a size of each of the mechanical device and the electric device to which the converter is applied is not particularly limited as well. Specifically, referring to an actuator as an example of the application of the converter, a size of the actuator may be a relatively-large size that allows easy handling by a human or a relatively-small size that does not allow for easy handling by a human.

In applications to which the converter of the invention is applied, it is possible to obtain some advantages in accordance with the application to which the converter is applied, owing to obtaining of superior conversion characteristics of the converter, as described above.

As described above, it is possible to obtain a great deformation amount, etc. by low consumed power, for example, in a case where the converter is applied to the mechanical device such as an actuator. Moreover, for example, in a case where the converter is applied to the electric device such as an electric generator, it is possible to obtain a great amount of electrostatic capacitance, a great amount of electric power generation, etc. Moreover, for example, in a case where the converter is applied to the detecting device such as a pressure sensor, it is possible to obtain superior detection accuracy.

### Examples

Examples of the invention are described below. The description is given in the following order. It is to be noted that the embodiment of the invention is not limited to embodiments described here.
1. Manufacturing of Converter
2. Evaluation of Converter
3. Discussion

### [1. Manufacturing of Converter]

### [Experiment Example 1]

A converter having the dielectric elastomer film 3 that expands and contracts in the surface direction (see FIG. 4) was manufactured by the following procedure.

First, a paste including a thermoset elastomer (a silicone-rubber-based elastomer A: SRA) and a curing catalyst were mixed. Thereafter, the mixture was stirred to obtain a mixed solution. In this case, a mixture ratio (a ratio by weight) between the paste and the catalyst was 97: 3. Thereafter, the mixed solution was applied, in a circle shape, on one surface of a supporting film (polyethylene terephthalate) by a roll coater. Thereafter, the applied mixed solution was dried to obtain the circle dielectric elastomer film 3 (thickness = 160 µm, relative dielectric constant ε1 = 2.8, diameter = 20 mm). Thereafter, the dielectric elastomer film 3 was peeled off from the supporting film.

Thereafter, a paste including a thermoset elastomer (a fluorosilicone-rubber-based elastomer: FSR) and a curing catalyst were mixed. Thereafter, the mixture was stirred to obtain a mixed solution. In this case, a mixture ratio (a ratio by weight) between the paste and the catalyst was 94: 6.

Thereafter, the mixed solution was applied, in a circle shape, onto one surface of the dielectric elastomer film 3 by a spin coater. Thereafter, the applied mixed solution was dried to allow for a reaction (thermosetting) of the thermoset elastomer. The elastomer 61 (a fluorosilicone-rubber-based elastomer, relative dielectric constant ε3 = 6.9) was thereby formed. Accordingly, the circle first high-dielectric-constant film 6 (thickness = 20 µm, relative dielectric constant ε2 = 6.9, diameter = 20 mm) including the elastomer 61 was formed.

Similarly, the mixed solution was applied, in a circle shape, onto the other surface of the dielectric elastomer film 3 by a spin coater. Thereafter, the applied mixed solution was dried to thereby allow for a reaction (thermosetting) of the thermoset elastomer. The elastomer 71 (a fluorosilicone-rubber-based elastomer, relative dielectric constant ε3 = 6.9) was thereby formed. Accordingly, the circle second high-dielectric-constant film 7 (thickness = 20 µm, relative dielectric constant ε2 = 6.9, diameter = 20 mm) including the elastomer 71 was formed.

Lastly, an electrically-conductive paste (a carbon paste) was printed in a circle shape on a surface of the first high-dielectric-constant film 6. Thereafter, the applied electrically-conductive paste was dried to form the circle first electrode 1 (diameter = 20 mm). Similarly, an electrically-conductive paste (a carbon paste) was printed in a circle shape on a surface of the second high-dielectric-constant film 7. Thereafter, the applied electrically-conductive paste was dried to form the circle second electrode 2 (diameter = 20 mm).

Thus, a converter including the first high-dielectric-constant film 6 and the second high-dielectric-constant film 7 was completed.

### [Experiment Example 2]

A converter (see FIG. 7) was manufactured by a procedure similar to that of Experiment example 1 except that the procedure of forming the dielectric elastomer film 3 was changed, and the first high-dielectric-constant film 8 and the second high-dielectric-constant film 9 were formed in place of the first high-dielectric-constant film 6 and the second high-dielectric-constant film 7.

In a case of obtaining the dielectric elastomer film 3, a mixture ratio (a ratio by weight) of a paste including a thermoset elastomer (a silicone-rubber-based elastomer B: SRB) and a curing catalyst was: paste: catalyst = 97: 3. The circle dielectric elastomer film 3 (thickness = 160 µm, relative dielectric constant ε1 = 2.7) was thereby obtained.

In a case of forming the first high-dielectric-constant film 8, a paste including a thermoset elastomer (a silicone-rubber-based elastomer B: SRB), a curing catalyst, and the plurality of particles 81 (barium titanate (BaTiO₃) available from KCM Corporation, median size = 50 nm, relative dielectric constant ε4 = 2000) were mixed. Thereafter, the mixture was stirred to obtain a mixed solution. In this case, a mixture ratio (a ratio by weight) between the paste, the catalyst, and the plurality of particles 81 was = 86: 4: 10. Thereafter, the mixed solution was applied, in a circle shape, on one surface of the dielectric elastomer film 3. Thereafter, the applied mixed solution was dried to thereby allow for a reaction (thermosetting) of the thermoset elastomer. The elastomer 82 (the silicone-rubber-based elastomer B: SRB, relative dielectric constant ε5 = 2.7) was thereby formed. Accordingly, the circle first high-dielectric-constant film 8 (thickness = 20 µm, relative dielectric constant ε2 = 3.1) including the elastomer 82 and the plurality of particles 81 was formed.

Similarly, in a case of forming the second high-dielectric-constant film 9, a paste including a thermoset elastomer (a silicone-rubber-based elastomer B: SRB), a curing catalyst, and the plurality of particles 91 (barium titanate available from KCM Corporation, median size = 50 nm, relative dielectric constant ε4 = 2000) were mixed. Thereafter, the mixture was stirred to obtain a mixed solution. In this case, a mixture ratio (a ratio by weight) between the paste, the catalyst, and the plurality of particles 91 was = 86: 4: 10. Thereafter, the mixed solution was applied, in a circle shape, on the other surface of the dielectric elastomer film 3. Thereafter, the applied mixed solution was dried to thereby allow for a reaction (thermosetting) of the thermoset elastomer. The elastomer 92 (the silicone-rubber-based elastomer B: SRB, relative dielectric constant ε5 = 2.7) was thereby formed. Accordingly, the circle second high-dielectric-constant film 9 (thickness = 20 µm, relative dielectric constant ε2 = 3.1) including the elastomer 92 and the plurality of particles 91 was formed.

### [Experiment Example 3]

A converter (see FIG. 7) was manufactured by a procedure similar to that of Experiment example 2 except that the material (the elastomer) of forming each of the dielectric elastomer film 3, the first high-dielectric-constant film 8, and the second high-dielectric-constant film 9 was changed.

In a case of obtaining the dielectric elastomer film 3, a mixture ratio (a ratio by weight) of a paste including a thermoset elastomer (a urethane-rubber-based elastomer: UR) and a curing catalyst was: paste: catalyst = 99: 1. The circle dielectric elastomer film 3 (thickness = 420 µm, relative dielectric constant ε1 = 3.1) was thereby obtained.

In a case of forming the first high-dielectric-constant film 8, the paste including the thermoset elastomer (the urethane-rubber-based elastomer: UR), the curing catalyst, and the plurality of particles 81 (barium titanate available from KCM Corporation, median size = 50 nm, relative dielectric constant ε4 = 2000) were mixed. Thereafter, the mixture was stirred to obtain a mixed solution. In this case, a mixture ratio (a ratio by weight) between the paste, the catalyst, and the plurality of particles 81 was = 86: 4: 10. Thereafter, the mixed solution was applied, in a circle shape, on one surface of the dielectric elastomer film 3. Thereafter, the applied mixed solution was dried to thereby allow for a reaction (thermosetting) of the thermoset elastomer. The elastomer 82 (the urethane-rubber-based elastomer: UR, relative dielectric constant ε5 = 3.1) was thereby formed. Accordingly, the circle first high-dielectric-constant film 8 (thickness = 40 µm, relative dielectric constant ε2 = 3.6) including the elastomer 82 and the plurality of particles 81 was formed.

Similarly, in a case of forming the second high-dielectric-constant film 9, a paste including a thermoset elastomer (an urethane-rubber-based elastomer: UR), a curing catalyst, and the plurality of particles 91 (barium titanate available from KCM Corporation, median size = 50 nm, relative dielectric constant ε4 = 2000) were mixed. Thereafter, the mixture was stirred to obtain a mixed solution. In this case, a mixture ratio (a ratio by weight) between the paste, the catalyst, and the plurality of particles 91 was = 86: 4: 10. Thereafter, the mixed solution was applied, in a circle shape, on the other surface of the dielectric elastomer film 3. Thereafter, the applied mixed solution was dried to thereby allow for a reaction (thermosetting) of the thermoset elastomer. The elastomer 92 (the urethane-rubber-based elastomer, relative dielectric constant ε5 = 3.1) was thereby formed. Accordingly, the circle second high-dielectric-constant film 9 (thickness = 40 µm, relative dielectric constant ε2 = 3.6) including the elastomer 92 and the plurality of particles 91 was formed.

### [Experiment Example 4]

A converter (see FIG. 10) was manufactured by a procedure similar to that of Experiment example 1 except that none of the first high-dielectric-constant film 6 and the second high-dielectric-constant film 7 was formed and the thickness of the dielectric elastomer film 3 was 200 µm. In this case, the first electrode 1 was formed on one surface of the dielectric elastomer film 3 and the second electrode 2 was formed on the other surface thereof.

### [Experiment Example 5]

A converter (see FIG. 10) was manufactured by a procedure similar to that of Experiment example 2 except that none of the first high-dielectric-constant film 8 and the second high-dielectric-constant film 9 was formed and the thickness of the dielectric elastomer film 3 was 200 µm.

### [Experiment Example 6]

A converter (see FIG. 10) was manufactured by a procedure similar to that of Experiment example 3 except that none of the first high-dielectric-constant film 8 and the second high-dielectric-constant film 9 was formed and the thickness of the dielectric elastomer film 3 was 500 µm.

### [Experiment Example 7]

A converter (see FIG. 10) was manufactured by a procedure similar to that of Experiment example 4 except that the material (the elastomer) of forming the dielectric elastomer film 3 was changed.

In a case of obtaining the dielectric elastomer film 3, the mixture ratio (the ratio by weight) of a paste including a thermoset elastomer (a fluorosilicone-rubber-based elastomer: FSR) and a curing catalyst was: paste: catalyst = 97: 3. The circle dielectric elastomer film 3 (thickness = 200 µm, relative dielectric constant ε1 = 6.9) was thereby obtained.

### [Experiment Example 8]

A converter was manufactured by a procedure similar to that of Experiment example 7 except that a film (a low-dielectric-constant film) having relative dielectric constant ε6 that was lower than the relative dielectric constant ε1 was formed on each of one surface and the other surface of the dielectric elastomer film 3.

In a case of forming the low-dielectric-constant film, a paste including a thermoset elastomer (a silicone-rubber-based elastomer: SRA) and a curing catalyst were mixed. Thereafter, the mixture was stirred to obtain a mixed solution. In this case, a mixture ratio (a ratio by weight) between the paste and the catalyst was 97: 3. Thereafter, the mixed solution was applied, in a circle shape, on each of one surface and the other surface of the dielectric elastomer film 3. Thereafter, the applied mixed solution was dried to thereby allow for a reaction (thermosetting) of the thermoset elastomer. The elastomer (the silicone-rubber-based elastomer A: SRA, relative dielectric constant ε6 = 2.8) was thereby formed. Accordingly, the circle low-dielectric-constant film (thickness = 20 µm, relative dielectric constant ε2 = 2.8) including the elastomer was formed.

It is to be noted that the configuration of the low-dielectric-constant film (the type of the elastomer and the value of the relative dielectric constant ε6) is described in a section of each of the first high-dielectric-constant film and the second high-dielectric-constant film in Table 1 for comparison.

### [2. Evaluation of Converter]

Conversion characteristics of the respective converters were examined, and results described in Table 1 were obtained. Here, deformation characteristics in a case where the converter was used as the mechanical device (an actuator) was examined, and electric power generation characteristics in a case where the converter was used as the electric device (an electric generator) were examined.

In a case of examining the deformation characteristics, a voltage was applied between the first electrode 1 and the second electrode 2 to thereby cause the dielectric elastomer film 3 to expand in the surface direction, until the dielectric elastomer film 3 was broken. An expansion amount (the maximum expansion amount) of the dielectric elastomer film 3 was thereby measured. The voltage at the time of the breaking of the dielectric elastomer film 3 (the highest applied voltage: kV/100 µm) was as described in Table 1.

In a case of examining the electric power generation characteristics, external force was so supplied to the converter that the expansion amount of the dielectric elastomer film 3 was 40% to thereby cause the dielectric elastomer film 3 to expand in the surface direction. An amount of electric power generated at the time of the expansion of the dielectric elastomer film 3 was thereby measured.

It is to be noted that presence or absence of a leakage current was also examined by a high-voltage-compatible digital multimeter in the cases of examining the deformation characteristics and the electric power generation characteristics.

Table 1 describes a normalized value (a value rounded off to the closest whole number) as a value of each of the expansion value and the electric power generation value. Specifically, a value of Experiment example 1 is a value that is normalized on the basis of a value of Experiment example 4 as 1.00. A value of Experiment example 2 is a value that is normalized on the basis of a value of Experiment example 5 as 1.00. A value of Experiment example 3 is a value that is normalized on the basis of a value of Experiment example 6 as 1.00. A value of Experiment example 8 is a value that is normalized on the basis of a value of Experiment example 7 as 1.00.

**[Table 1]**

| Experiment example | First high-dielectric-constant film | | | Dielectric elastomer film | | Second high-dielectric-constant film | | | Highest application voltage (kV/100 µm) | Expansion amount (normalized) | Electric power generation amount (normalized) | Leakage current |
|---|---|---|---|---|---|---|---|---|---|---|---|---|
| | Elastomer | Particles | ε2 | Elastomer | ε1 | Elastomer | Particles | ε2 | | | | |
| 1 | FSR (ε3=6.9) | - | 6.9 | SRA | 2.8 | FSR (ε3=6.9) | - | 6.9 | 8.8 | 1.15 | 1.22 | Absent |
| 2 | SRB (ε5=2.7) | BaTiO₃ (ε4=2000) | 3.1 | SRB | 2.7 | SRB (ε5=2.7) | BaTiO₃ (ε4=2000) | 3.1 | 9.0 | 1.12 | 1.11 | Absent |
| 3 | UR (ε5=3.1) | BaTiO₃ (ε4=2000) | 3.6 | UR | 3.1 | UR (ε5=3.1) | BaTiO₃ (ε4=2000) | 3.6 | 7.5 | 1.12 | 1.09 | Absent |
| 4 | - | - | - | SRA | 2.8 | - | - | - | 7.5 | 1.00 | 1.00 | Absent |
| 5 | - | - | - | SRB | 2.7 | - | - | - | 7.6 | 1.00 | 1.00 | Absent |
| 6 | - | - | - | UR | 3.1 | - | - | - | 6.6 | 1.00 | 1.00 | Present |
| 7 | - | - | - | FSR | 6.9 | - | - | - | 4.5 | 1.00 | 1.00 | Absent |
| 8 | SRA (ε6=2.8) | - | 2.8 | FSR | 6.9 | SRA (ε6=2.8) | - | 2.8 | 4.0 | 0.88 | 0.71 | Absent |

| | | | | | | | | | | | | |
|---|---|---|---|---|---|---|---|---|---|---|---|---|
| SRA: silicone-rubber-based elastomer A, SRB: silicone-rubber-based elastomer B, FSR: fluorosilicone-rubber-based elastomer, UR: urethane-rubber-based elastomer | | | | | | | | | | | | |

### [3. Discussion]

As is apparent from Table 1, the deformation characteristics and the electric power generation characteristics of the converter were varied greatly in accordance with the configuration of the converter as described below.

In the case (Experiment example 1) where the first high-dielectric-constant film 6 and the second high-dielectric-constant film 7 (the elastomers 61 and 71 that were the highly-dielectric materials) were used, both of the expansion amount and the electric power generation amount were higher compared with those in the case (Experiment example 4) where none of the first high-dielectric-constant film 6 and the second high-dielectric-constant film 7 was used.

Moreover, in the case (Experiment example 2) where the first high-dielectric-constant film 8 and the second high-dielectric-constant film 9 (the plurality of particles 81 and 91 that were the highly-dielectric materials) were used, both of the expansion amount and the electric power generation amount were higher compared with those in the case (Experiment example 5) where none of the first high-dielectric-constant film 8 and the second high-dielectric-constant film 9 was used.

In the case where the first high-dielectric-constant film 8 and the second high-dielectric-constant film 9 were used, a similar result was obtained also when the material of forming the dielectric elastomer film 3 was changed (Experiment examples 3 and 6).

In particular, in the case where the urethane-rubber-based elastomer (UR) was used as the material of forming the dielectric elastomer film 3, the leakage current was not generated when the first high-dielectric-constant film 8 and the second high-dielectric-constant film 9 were used (Experiment example 3) but the leakage current (= 20 µA) was generated when none of the first high-dielectric-constant film 8 and the second high-dielectric-constant film 9 was used (Experiment example 6).

It is to be noted that the case (Experiment example 8) where the low-dielectric-constant film was used, both of the expansion amount and the electric power generation amount were lower compared with those in the case (Experiment example 7) where the low-dielectric-constant film was not used.

As can be appreciated from the results described in Table 1, both of the expansion amount and the electric power generation amount were increased on a condition that: the first high-dielectric-constant film 6 or 8 having the relative dielectric constant ε2 higher than the relative dielectric constant ε1 of the dielectric elastomer film 3 was disposed between the first electrode 1 and the dielectric elastomer film 3; and the second high-dielectric-constant film 7 or 9 having the relative dielectric constant ε2 higher than the relative dielectric constant ε1 of the dielectric elastomer film 3 was disposed between the second electrode 2 and the dielectric elastomer film 3. Hence, superior conversion characteristics of the converter were obtained.

It is to be noted that specific verification was not performed regarding a case where: the first high-dielectric-constant film 6 or 8 was disposed between the first electrode 1 and the dielectric elastomer film 3; and the second high-dielectric-constant film 7 or 9 was not disposed between the second electrode 2 and the dielectric elastomer film 3. Similarly, specific verification was not performed regarding a case where: the first high-dielectric-constant film 6 or 8 was not disposed between the first electrode 1 and the dielectric elastomer film 3; and the second high-dielectric-constant film 7 or 9 was disposed between the second electrode 2 and the dielectric elastomer film 3.

However, it is certain both technically and logically that the conversion characteristics of the converter are improved by using both of the first high-dielectric-constant film 6 or 8 and the second high-dielectric-constant film 7 or 9 compared with a case where none of the first high-dielectric-constant film 6 or 8 or the second high-dielectric-constant film 7 or 9 is used. This is also certain from the results of the experiments described above. Therefore, if the conversion efficiency is improved in the case where both the first high-dielectric-constant film 6 or 8 and the second high-dielectric-constant film 7 or 9 are used, the conversion efficiency should be similarly improved also in a case where only the first high-dielectric-constant film 6 or 8 is used and a case where only the second high-dielectric-constant film 7 or 9 is used.

Although the invention has been described above referring to the embodiments and Examples, the invention is not limited to the modes described above regarding the embodiments and Examples and is modifiable in various ways.

Specifically, the converter of the invention is not limited to the applications described above, and is applicable to other applications. Also in such cases, superior conversion characteristics are obtainable. Therefore, it is possible to effectively exhibit various functions that utilize conversion of a physical quantity.

This application claims the priority on the basis of Japanese Patent Application No. 2016-002330 filed on January 8, 2016 with the Japan Patent Office, the entire contents of which are incorporated in this application by reference.

It should be understood by those skilled in the art that various modifications, combinations, sub-combinations, and alterations may occur depending on design requirements and other factors insofar as they are within the scope of the appended claims or the equivalents thereof.

## Claims

1. A converter comprising:
a first electrode;
a second electrode;
a dielectric elastomer film that is disposed between the first electrode and the second electrode, and has relative dielectric constant ε1; and
a high-dielectric-constant film that is disposed at one or both of: a location between the first electrode and the dielectric elastomer film; and a location between the second electrode and the dielectric elastomer film, the high-dielectric-constant film having relative dielectric constant ε2 that is higher than the relative dielectric constant ε1.

2. The converter according to claim 1, wherein
the high-dielectric-constant film includes an elastomer, and
the elastomer has relative dielectric constant ε3 that is higher than the relative dielectric constant ε1.

3. The converter according to claim 1, wherein
the high-dielectric-constant film includes a plurality of particles and an elastomer, and
the plurality of particles have relative dielectric constant ε4 that is higher than the relative dielectric constant ε1.

4. The converter according to claim 3, wherein the plurality of particles include one or both of barium titanate and a derivative thereof.
